# EUROPEAN PATENT APPLICATION

(11) **EP 4 428 916 A1**
(43) Date of publication of application: **11.09.2024**
(21) Application number: 23161033.8
(22) Date of filing: 09.03.2023
(51) Int. Cl.: H01L 23/495

(54) **POWER TRANSISTOR CHIP PACKAGE**

(71) Applicant: Infineon Technologies Austria AG, 9500 Villach (AT)
(72) Inventor: OTREMBA, Ralf, 87600 Kaufbeuren (DE); AICHRIEDLER, Leo, 9722 Puch (AT); HOELZL, Daniel, 82008 Unterhaching (DE); WRIESSNEGGER, Gerald, 9500 Villach (AT); NAYAK, Soumya Susovita, 81549 München (DE)
(74) Representative: Lambsdorff & Lange Patentanwälte Partnerschaft mbB

(57) **Abstract**

A power transistor chip package (100A, 100B) includes a power transistor chip (120). The power transistor chip includes a first load electrode (122) on a first side (120_1), a second load electrode (124) on a second side (120_2) opposite the first side and a control electrode. The power transistor chip package further includes a chip pad (140) on which the power transistor chip is disposed. The first side faces the chip pad and the first load electrode is electrically connected to the chip pad. An encapsulation body (160) encapsulates the power transistor chip. The encapsulation body includes a footprint side(160F), a top side (160T) opposite the footprint side and side faces extending between the footprint side and the top side. The power transistor chip package further includes a first package load terminal electrically connected to the first load electrode of the power transistor chip, part I and part II second package load terminals (184_1, 184_2) both electrically connected directly to the second load electrode of the power transistor chip and a package control terminal electrically connected to the control electrode of the power transistor chip. The part I and part II second package load terminals are aligned with opposite sides faces of the encapsulation body.

## Description

### Technical Field

This disclosure relates generally to the technique of semiconductor packaging, and in particular to a power transistor chip packages including a power transistor chip.

### Background

Power transistor devices are widely used as electronic switches in a variety of electronic circuits. Higher efficiency, increased power density, improved thermal behavior, lower switching losses and lower cost are among the key goals for next generation power transistor chip package design.

While the R_{DS(on)} values of semiconductor transistor chips used in discrete power packages have steadily decreased over time, the resistance of the internal package interconnect remains constant. Therefore, the resistance of the internal package interconnect is becoming increasingly important to the R_{DS(on)} values of the overall device.

### Summary

According to an aspect of the disclosure a power transistor chip package includes a power transistor chip. The power transistor chip includes a first load electrode on a first side, a second load electrode on a second side opposite the first side and a control electrode. The power transistor chip package further includes a chip pad on which the power transistor chip is disposed. The first side of the power transistor chip faces the chip pad and the first load electrode is electrically connected to the chip pad. An encapsulation body encapsulates the power transistor chip. The encapsulation body includes a footprint side, a top side opposite the footprint side and side faces extending between the footprint side and the top side. The power transistor chip package further includes a first package load terminal electrically connected to the first load electrode of the power transistor chip, part I and part II second package load terminals both electrically connected directly to the second load electrode of the power transistor chip and a package control terminal electrically connected to the control electrode of the power transistor chip. The part I and part II second package load terminals are aligned with opposite sides faces of the encapsulation body.

According to an aspect of the disclosure a power circuit includes first and second power transistor chip packages as described above. The power circuit further includes a carrier, wherein the first and second power transistor chip packages are mounted at opposite sides to the carrier. First and second heat sinks are provided, wherein the first package load terminal of the first power transistor chip package is connected to the first heat sink and the first package load terminal of the second power transistor chip package is connected to the second heat sink.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1A is a schematic cross-sectional view of an example of a power transistor chip package with top side cooling (TSC) .
Figure 1B is a schematic cross-sectional view of an example of a power transistor chip package with back side cooling (BSC).
Figure 2 is a plan view of a power transistor chip disposed on a chip pad and package terminals connected to electrodes of the power transistor chip in accordance with a first example.
Figure 3 is a plan view of a power transistor chip disposed on a chip pad and package terminals connected to electrodes of the power transistor chip in accordance with a second example.
Figure 4 is a plan view of a power transistor chip disposed on a chip pad and package terminals connected to electrodes of the power transistor chip in accordance with a third example.
Figure 5 is a perspective bottom view of a power transistor chip disposed on a chip pad and package terminals connected to electrodes of the power transistor chip in accordance with the second example (Figure 3) for a TSC power transistor chip package as shown in Figure 7, for example.
Figure 6 is a perspective top view of an example of a power transistor chip package.
Figure 7 is a perspective top view of an example of a power transistor chip package.
Figure 8 illustrates perspective top views of two examples of power transistor chip packages.
Figure 9 is a schematic semi-transparent top view of an example of a power transistor chip package mounted on a carrier.
Figure 10 illustrates a top view and sectional views of an exemplary power circuit using a plurality of power transistor chip packages as described above.
Figure 11 is an electrical schematic of the exemplary power circuit of Figures 10 and 12.
Figure 12 illustrates a top view and a sectional view of an exemplary power circuit using a plurality of power transistor chip packages as described above.
Figure 13 is an electrical schematic of the exemplary power circuit of Figures 10 and 12 coupled to an exemplary circuit for current measurement.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

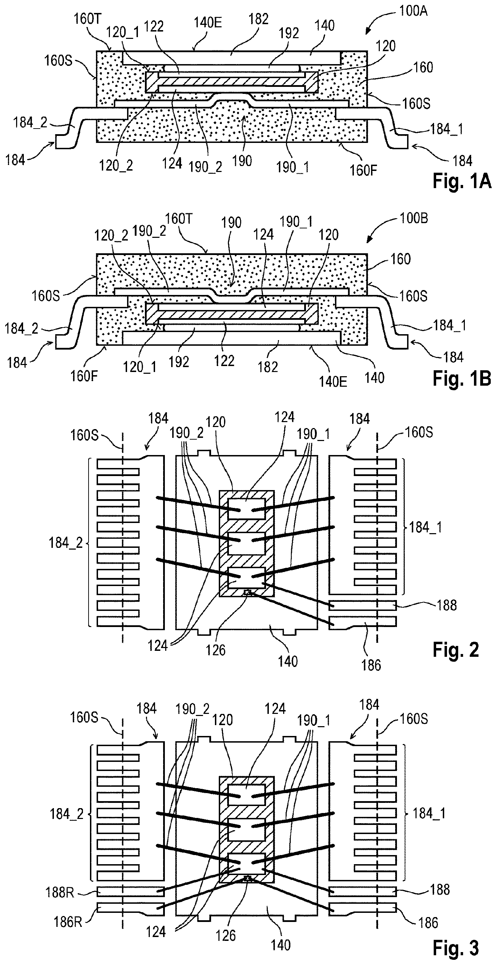

Figures 1A and 1B illustrate examples of power transistor chip packages 100A and 100B, respectively. Both power transistor chip packages 100A, 100B are discrete packages, i.e. packages which accommodate (only) one or a plurality of power transistor chips 120. While power transistor chip package 100A illustrates an example of a top side cooled (TSC) type chip package, power transistor chip package 100B illustrates an example of a bottom side cooled (BSC) type chip package.

Both packages 100A, 100B include a chip pad 140 on which the power transistor chip 120 is disposed. Further, an encapsulation body 160 encapsulates the power transistor chip 140 and, optionally, a part or the entire chip pad 140, for example.

The encapsulation body 160 includes a footprint side 160F and a top side 160T opposite the footprint side 160F. Side faces 160S of the encapsulation body 160 extend between the footprint side 160F and the top side 160T.

For example, in power transistor chip package 100A, the chip pad 140 may be exposed at the top side 160T of the encapsulation body 160. Analogously, in some examples such as, e.g., package 100B, the chip pad 140 may be exposed at the footprint side 160F of the encapsulation body 160. However, both in the TSC implementation (Figure 1A) and in the BSC implementation (Figure 1B) the chip pad 140 may, e.g., be covered by the encapsulation body 160 at its top side 160T or its footprint side 160F, respectively. Further, it is possible in both implementations that the chip pad 140 is not covered by the encapsulation body 160 but by an insulation foil or an insulation layer (e.g. a ceramic layer) having a lower thermal resistance than the material of the encapsulation body 160.

The power transistor chip 120 has a first load electrode 122 on a first side 120_1 and a second load electrode 124 on a second side 120_2 opposite the first side 120_1. Further, the power transistor chip 120 has a control electrode which is not apparent in the sectional views of Figures 1A and 1B.

The power transistor chip 120 may be a MOSFET (Metal Oxide Semiconductor Field Effect Transistor). In particular, it may be a superjunction (SJ) Si-MOSFET or SiC-MOSFET or JFET (Junction-FET).

The power transistor chip 120 may have a vertical structure, i.e. the electrical load current may flow in a direction perpendicular to the main sides 120_1, 120_2 of the power transistor chip 120.

The power transistor chip package 100A, 100B includes a first package load terminal 182 which is connected (e.g. soldered) to the first load electrode 122 of the power transistor chip 120. A solder joint is denoted by reference sign 192. In Figures 1A and 1B the first load terminal 182 may be directly or indirectly (e.g. by additional metallizations) provided by the exposed side 140E of the chip pad 140. In this case, the chip pad 140 is also referred to as an "exposed paddle" in the art.

The chip pad 140 is typically provided by a chip pad of a leadframe. For example, if the chip pad 140 has no exposed side 140E (e.g. because it is completely encapsulated by the encapsulation body 160), the first load terminal 182 may also be provided by a lead of the leadframe which connects to the chip pad 140 and may protrude from the power transistor chip package 100A, 100B at, e.g., a side face 160S thereof (not shown).

A second package load terminal 184 includes at least two separate parts, which are referred to as "part I second package load terminal 184_1" and "part II second package load terminal 184_2", respectively, in the following. The part I and the part II second package load terminals 184_1, 184_2 are each electrically connected directly (e.g., without any intervening component or connection) to the second load electrode 124 of the power transistor chip 120. Further, the power transistor chip package 100A, 100B includes a package control terminal (not shown in Figures 1A and 1B) which is electrically connected to the control electrode (not shown in Figures 1A and 1B) of the power transistor chip 120.

The part I and the part II second package load terminals 184_1 and 184_2, respectively, are aligned with opposite side faces 160S of the encapsulation body 160.

This implementation provides several advantages over a conventional approach, in which the second package load terminal 184 is aligned with only one side face 160S of the chip package 100A, 100B. First, this implementation allows to lower the electrical resistance of an electrical interconnect 190 configured to connect the second load electrode 124 to the second package load terminal 184 of the chip package 100A, 100B, thereby reducing the impact of the electrical interconnect on the R_{DS(on)} value of the overall device. Further, the "double side" (DS) approach for the second package load terminal 184 offers more terminal area for mounting the power transistor chip package 100A, 100B on an application board, thereby increasing the current carrying capacity. In addition, the enhanced degree of symmetry of the chip package 100A, 100B in terms of the DS second package load terminal 184 design may facilitate and/or improve circuitry layout on the application board, as will be shown by way of example further below.

In Figures 1A, 1B the (internal) electrical interconnect 190 may include a part I electrical interconnect 190_1 and a part II electrical interconnect 190_2. The part I electrical interconnect connects the second load electrode 124 to the part I second package load terminal 184_1. The part II electrical interconnect 190_2 connects the second load electrode 124 to the part II second package load terminal 184_2.

The part I electrical interconnect 190_1 and the part II electrical interconnect 190_2 may be separate connectors, for example. Alternatively, the part I electrical interconnect 190_1 and the part II electrical interconnect 190_2 may be made of a continuous connector which is connected to the second load electrode 124 at a middle portion of the one-piece connector.

For example, if the part I electrical interconnect 190_1 and the part II electrical interconnect 190_2 each comprise bond wires, a bond wiring process can be performed in which a bond wire is applied from one side of the power transistor chip package 100A to the other side (e.g., from left to right) without having a central origin on the chip as usual. This can reduce the cost of bond wiring.

The electrical resistance of the part I electrical interconnect 190_1 and the part II electrical interconnect 190_2 may be substantially equal. More generally, the respective electrical resistances may not differ from each other by more than 200 or 10% or 5%. That way, the part I and part II second package load terminal 184_1, 184_2 may each carry a substantial portion of the total load current, e.g. about 50% each.

The part I and part II electrical interconnect 190_1, 190_2 may each include one or a plurality of discrete connectors such as one or a plurality of bond wires or ribbons or clips, for example. Each discrete connector can be a single-piece connector that can make a direct connection, such as having connections to the respective parts only at its two ends. The cross-sectional area of the part I electrical interconnect 190_1 and the cross-sectional area of the part II electrical interconnect 190_2 may be similar, i.e. may not differ from each other by more than 200 or 10% or 5% percent. Percentages, as recited herein, always refer to the larger one of the compared values.

The power transistor chip packages 100A, 100B may be power SMD (Surface-Mounted-Device) packages. In this connection, it is to be noted that the part I second package load terminal 184_1 and the part II second package load terminal 184_2 may have a variety of shapes. For example, as shown in Figures 1A and 1B, the part I and part II second package load terminals 184_1, 184_2 may be leads or pins of a leadframe. These leads or pins may laterally protrude from the side faces 160S of the encapsulation body 160. The part I and part II second package load terminals 184_1, 184_2 may each be formed of a plurality of gull wing leads, for example. In other examples the leads or pins of the part I and part II second package load terminals 184_1, 184_2 may each be formed of a plurality of straight leads or pins. Further, the part I and part II second package load terminals 184_1, 184_2 may, e.g., each be formed by a plurality of conductive pads exposed at the footprint side 160F of the encapsulation body 160. In other words, the chip packages 100A, 100B may, alternatively, be designed as no-lead packages using a planar leadframe for the package load terminals at the footprint side 160F of the encapsulation body 160.

The power transistor chip packages 100A, 100B may contain a single power transistor chip as, e.g., illustrated in the various examples. In other examples, the power transistor chip packages 100A, 100B may contain multiple (e.g., identical) power transistor chips which are connected in parallel to each other. That is, each power transistor chip may be connected to the part I and part II second package load terminals 184_1, 184_2 and to the (e.g., common) chip pad 140 as described above for the single power transistor chip 120.

Figures 2 to 4 illustrate various examples of chip package terminals and internal interconnects available for all types of power transistor chip packages 100A, 100B described herein. Depending on whether the chip package is a TSC chip package 100A or a BSC chip package 100B, the illustrations of Figures 2 to 4 are bottom views or top views, respectively. The encapsulation body 160 is omitted for illustration.

The power transistor chip 120 bonded to the chip pad 140 is provided with a second load electrode 124 having three contact fields, for example. The part I electrical connect 190_1 and the part II electrical interconnect 190_2 each includes three bond wires, for example. Further, a package control terminal 186 is connected to the control electrode 126 of the power transistor chip 120.

Optionally, the chip package may further include a package sense terminal 188, which is connected to the second load electrode 124. The package sense terminal 188 is also referred to as a Kelvin pin in the art.

The package control terminal 186 and the package sense terminal 188 may be aligned with the same side face 160S face 160S of the encapsulation body 160. For example, they may be aligned with the side face 160S of the encapsulation body 160 along which the part I second package load terminals 184_1 are aligned (Figures 2 to 4).

Referring to the first example illustrated in Figure 2, the part I second package load terminals 184_1 may be aligned along the entire side face 160S of the encapsulation body 160. No further package terminals may be arranged along this side face 160S of the package, for example.

Referring to the second example illustrated in Figure 3, the chip package may contain an additional package control terminal 186R. The additional control terminal 186R may be a redundant or spare package control terminal which, e.g., can either be used together with the package control terminal 186 to enhance electrical connectivity safety to the application board or may be used instead of the package control terminal 186 to enhance the wiring flexibility on the application board.

Still referring to Figure 3, the chip package may additionally or alternatively further include an additional package sense terminal 188R. For example, the package sense terminal 188 and the additional package sense terminal 188R may be aligned with opposite side face 160S of the encapsulation body 160. Hence, the options illustrates in Figure 3 may be used to increase the reliability and/or versatility of the chip package.

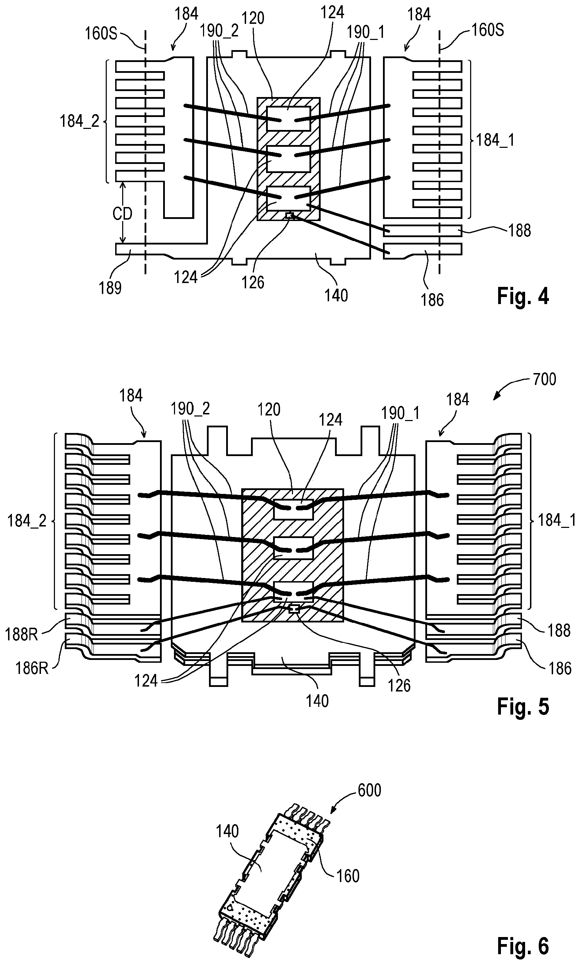

Referring to the third example (Figure 4), the chip package may further include a package signal terminal 189, which is connected to the first load electrode 122 of the power transistor chip 120. The package signal terminal 189 may, e.g. be aligned at a side face 160S opposite to the side face 160S at which the package control terminal 186 and/or the package sense terminal 188 is aligned.

In other words, a package terminal is directly connected to the chip pad 140, for example. As a result, the chip pad potential, which is only available at the top 160T of the package in the TSC chip package 100A, is also available at the bottom 160S of the package and can thus be used on the application board. As will be described in more detail below, this allows for easy current measurement, for example.

As shown in Figure 4, the package signal terminal 189 may be spaced apart from the part II second package load terminal 184_2 by a creepage distance CD. The creepage distance CD is chosen to account for the potential difference of several hundred volts between the high voltage package signal terminal 189 and the low voltage part II second package load terminal 184_2.

In all examples of chip packages, all package terminals may be aligned with only two sides of the chip package. Differently stated, two other sides of the chip package may be void of any package terminals, for example.

By way of example and without loss of generality, the first load electrode 122 may be the drain electrode of the power transistor chip 120, the second load electrode 124 may be the source electrode of the power transistor chip 120 and the control electrode 126 may be the gate electrode of the power transistor chip 120. In this electrode allocation. the chip package 100A, 100B may be termed a "double side source" (DSS) chip package.

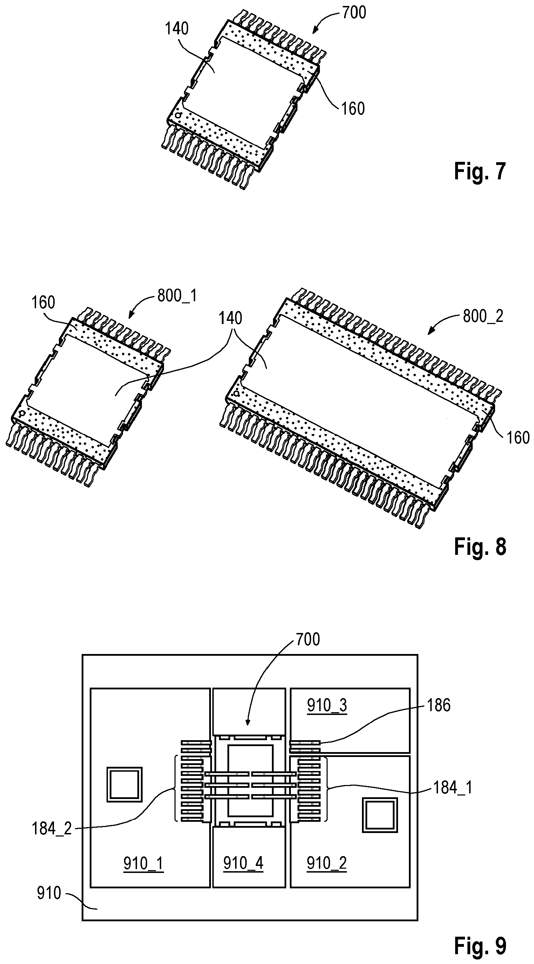

Figure 5 illustrates a perspective view in accordance with the second example (Figure 3) for a TSC chip package as, e.g., illustrated in Figure 1A. The power transistor chip package can be designed like the QDPAK-TSC package of Infineon^{®} shown in Figure 7.

In the example of Figure 5 all package terminals are formed as gull wing leads. The part I and part II electrical interconnects 190_1, 190_2 are formed by bond wires. The following is a calculation example of the contribution of the resistance of the bond wires to the total device resistance.

### Conventional single side source interconnect:

Given the R_{DS(on)}*A of a power transistor chip 120 (e.g. JFET (junction field effect transistor) is 55 mΩmm². Assuming a chip area A of 28 mm² the transistor chip R_{DS(on)} = 1.96 mΩ. Assuming a bond wire length of 9.75 mm and a bond wire diameter of 0.5 mm, the bond wire resistance of the three parallel bond wires (single side source) is 1/3*2.65*10⁻²Ωmm²/m*9.75 mm/0.196 mm² = 0.439 mΩ. Therefore, the device R_{DS(on)} = 1.96 mΩ + 0.439 mΩ = 2.399 mΩ.

### DSS interconnect:

For the DSS package 700 shown in Figure 5, the bond wire resistance is half of the conventional value, i.e. 0.219 mΩ. Hence, the device R_{DS(on)} = 1.96 mΩ + 0.219 mΩ = 2.179 mΩ.

Introducing the second source connection (i.e. the part II electrical interconnect 190_2) reduces the device R_{DS(on)} value by 9.2%. Compared to achieving the same device R_{DS(on)} with the conventional approach, in which the source package terminal is aligned with only one side face 160S of the encapsulation body 160, the active area A of the power transistor chip 120 can be reduced by 9%. Since in discrete power transistor chip packages the chip is the main cost factor, while packaging costs are considerably lower, this reduction in chip size is a significant advantage in practice.

Figures 6 to 8 illustrate examples of power transistor chip packages 600, 700, 800_1, 800_2. The power transistor chip package 600 is a conventional transistor package of Infineon^{®} referred to as DDPAK-TSC. The power transistor chip package 700 is a conventional transistor package of Infineon^{®} referred to as QDPAK-TSC. For example, the assembly shown in Figure 7 may be accommodated in a power transistor chip package 700. The power transistor chip packages 800_1 and 800_2 are conventional transistor packages of Infineon^{®} referred to as HexaDPAK-TSC/BSC and OctaDPAK-TSC/BSC, respectively. All these power transistor chip packages 600, 700, 800_1, 800_2 may, e.g., be used to implement the DSS approach as described above.

All power transistor chip packages disclosed herein may, e.g., be power SMD packages. Further, all power transistor chip packages disclosed herein may, e.g., provide at least one of BSC and/or TSC capability.

All power transistor chip packages disclosed herein may be configured for switching voltages equal to or greater than 200 V, 400 V, 600 V, 800 V, 1 kV, 1.2 kV and/or currents equal to or greater than 20 A, 40 A, 60 A, 70 A, 80 A. All power transistor chip packages disclosed herein may be configured for high current implementations such as, e.g., Smart Circuit Breakers, Solid State HV Relays, DC e-Fuses and Battery Main Switches.

The power transistor chip packages disclosed herein may be mounted on an application board 910, e.g. a PCB. Figure 9 is an example illustration for, e.g., QDPAK package of Figure 7 having an internal interconnect as shown in Figure 2. The part II second package load terminal 184_2 is connected (e.g. soldered) to a first metallization 910_1 provided on the application board 910. The part II second package load terminal 184_2 (e.g. the additional source leads of the package) is connected (e.g. soldered) to a second metallization 910_2 on the application board 910. The package control terminal 186 (e.g. gate lead) is connected (e.g. soldered) to a third metallization 910_3 on the application board 910. Further, the application board 910 may be provided with a central metallization 910_4. The central metallization 910_4 may, e.g., be connected (e.g. soldered) to the chip pad 140 (in case of a BSC package type as, e.g., shown in Figure 1B) and may take benefit of advanced PCB features such as, e.g., power inlays and/or thermal vias.

On the other hand, if the power transistor chip package 700 is of the TSC type, the first package load terminal 182 is at the top of the chip package 700 and the corresponding potential (e.g. drain potential) is not available at the application board 910 (except if the chip package 700 is provided with a package signal terminal 189, as shown in Figure 4).

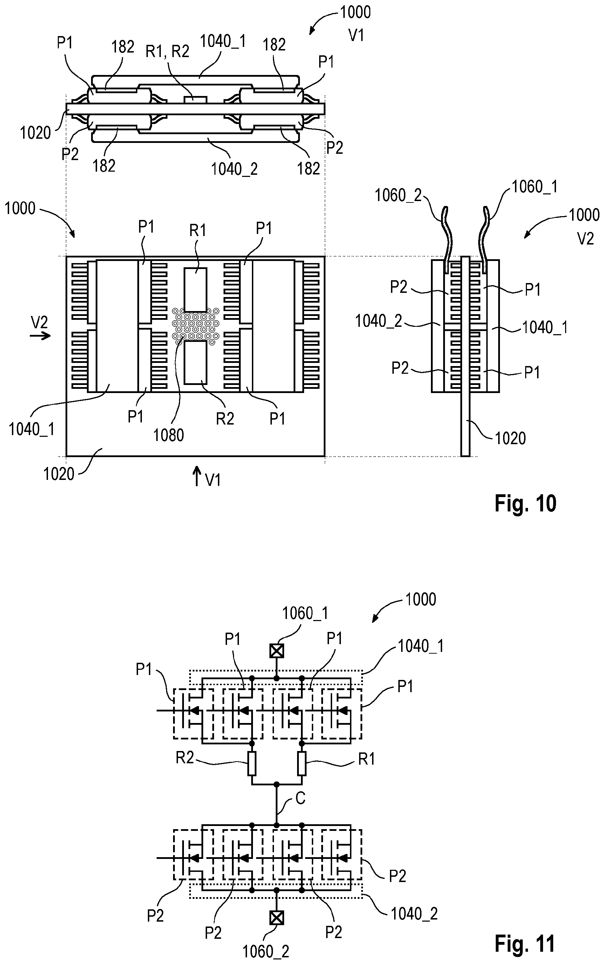

The power transistor chip packages described herein may be used in a variety of different applications. For example, Figure 10 illustrates an exemplary power circuit using eight power transistor chip packages. The lower left part of Figure 10 illustrates a top view on the power circuit 1000 (wherein a top heat sink 1040_1 is shown transparent in a middle portion between opposing first package load terminals 182 of chip packages P1 beneath). The upper left part of Figure 10 illustrates a side view in viewing direction V1. The lower right part of Figure 10 illustrates a side view in viewing direction V2. The electrical schematic of the power circuit 1000 is shown in Figure 11.

The power circuit 1000 includes a carrier 1020 on which the power transistor chip packages are mounted at opposite sides of the carrier 1020. The power transistor chip packages mounted on one side of the carrier 1020 are referred to by reference sign P1, while the power transistor chip package mounted on the opposite side of the carrier 1020 are referred to by reference sign P2. As shown in the lower left portion of Figure 10, pairs of power transistor chip packages P1, P1 and pairs of power transistor packages P2, P2 may be arranged in two rows at each side of the carrier 1020.

Many different arrangements in terms of the number, grouping, or location of power transistor chip packages P1, P1 on carrier 1020 are possible, and the disclosure herein relates to each possible arrangement. In particular, a power circuit 1000 may contain only two power transistor chip packages P1, P2, e.g. one package at each side of the carrier 1020.

The power circuit 1000 may include a first heat sink 1040_1 and a second heat sink 1040_2. In some examples, the first package load terminal 182 of each of the chip packages P1 is connected to the first heat sink 1040_1 and the first package load terminal 182 of each of the chip packages P2 is connected to the second heat sink 1040_2. More specifically, each first package load terminal 182 may be directly connected, e.g. by soldering, to the first heat sink 1040_1 and/or each first package load terminal 182 of each of the chip packages P2 may be directly connected, e.g. by soldering, to the second heat sink 1040_2.

In other examples (not shown), a plurality of first heat sinks 1040_1 and/or a plurality of second heat sinks 1040_2 may be provided, and the first heat sinks 1040_1 and/or the second heat sinks 1040_2 may be interconnected by electrical connections in series (daisy chain), respectively. In this case, each chip package P1 or a subset of chip packages P1 may be connected to a specific heat sink 1040_1 and/or each chip package P2 or a subset of chip packages P2 may be connected to a specific heat sink 1040_2.

The first and second heat sinks 1040_1, 1040_2 may provide for a thermal mass of the power circuit 1000. That is, the heat sinks 1040_1, 1040_2 typically provide for a thermal capacity which is high enough to compensate thermal power peaks occurring during operation in the chip packages P1, P2. The first and second heat sinks 1040_1, 1040_2 are also referred to as "heat slugs" or "heat distribution bars" in the art.

First and/or second power connectors 1060_1, 1060_2 may, e.g., be connected to the first and/or second heat sinks 1040_1, 1040_2, respectively. Hence, in this example, the power circuit 1000 is configured to tap the potential at the first package load terminal 182 (e.g. drain potential) simultaneously with the device cooling. The first and/or second heat sinks 1040_1, 1040_2 serve, in this example, a thermal and an electrical function, namely to provide the power connectivity of the power circuit 1000 for the respective chip packages P1, P2 and to provide for TSC capability by collecting and distributing the heat generated in the respective chip package P1 and P2. In other words, the first and/or second heat sinks 1040_1, 1040_2 each form part of the electrical power connection between a power terminal of the power circuit 1000 (e.g., the first and/or second power connectors 1060_1, 1060_2) and a first package load terminal 182 (e.g. drain of a power transistor chip 120). Hence, the power circuit 1000 is specifically suited for TSC chip packages (which may optionally also provide a BSC feature).

The first and/or second power connectors 1060_1, 1060_2 of the power circuit 1000 may, e.g., be implemented by flexible cables.

Referring to Figure 11, the chip packages P1 may be connected to the chip packages P2 in an anti-series connection. This connection C may, e.g., be formed on the carrier 1020. For example, the connection C may be formed by a feed-through connection including, e.g., a plurality of vias 1080 running through the carrier 1020 and connecting the part I and/or part II second package load terminals 184_1, 184_2 of the chip packages P1 to the part I and/or part II second package load terminals 184_1, 184_2 of the chip packages P2. Differently stated, the second package load terminals 184 of the chip packages P1 and P2 are short-circuited by the (e.g., carrier-based) connection C, which may, e.g., be a feed-through connection.

The power circuit 1200 may further be adapted to provide a possibility for current measurement. To this end, optionally, at least one component (resistor, inductor, etc.) (here: two resistors R1, R2, for example) may be used and may be connected in series with the (feed-through) connection C. The component may be used for current measurement, as will be described further below.

Due to its symmetry, compactness, high thermal capacity and advanced high current chip packages P1, P2, a high performance power circuit 1000 is provided.

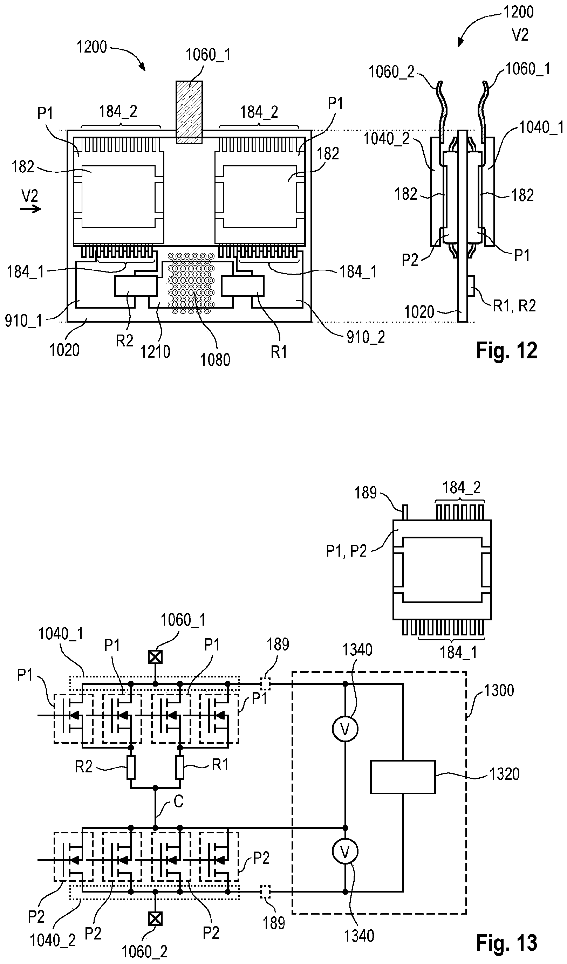

Figure 12 illustrates an exemplary power circuit 1200. The power circuit 1200 is similar to the power circuit 1000 and reference is made to the above description in order to avoid reiteration. The electrical schematic of Figure 11 also applies to power circuit 1200, except that power circuit 1200 includes, by way of example, only two chip packages P1 and two chip packages P2.

The power circuit 1200 distinguishes from the power circuit 1000 in that the (feed-through) connection C is located aside the chip packages P1, P2 rather than between the chip packages P1, P2 as in power circuit 1000. Further, only the part I second package load terminals 184_1 rather than also the part II second package load terminals 184_2 may be used. In addition, Figure 12 shows first and second metallizations 910_1, 910_2 (see Figure 9) which are connected via the resistors R2 and R1, respectively, to a feed-through metallization 1210 which connects to (feed-through) connection C represented by vias 1080, for example.

For example, the electrical resistance of resistors R1, R2 may be the same. The electrical resistance may be about 0.2 mΩ, for example. In other examples, other components than resistors may be used for current measurement.

A circuit for current measurement 1300 may be coupled to the power circuit 1000, 1200. Figure 13 illustrates an example in which chip packages P1, P2 in accordance with the third example (Figure 4) are used, for example. These chip packages P1, P2 are provided with the package signal terminal 189 configured to route the potential at the first package load terminal 182 (e.g. drain potential) down to the carrier 1020.

The circuit for current measurement 1300 may be provided on the carrier 1020 or on another carrier (not shown). The circuit for current measurement 1300 may include a current supply circuit 1320 and, e.g., voltage measurement devices 1340. If an over-current is detected by the voltage measurement devices 1320, the transistor chips in chip packages P1, P2 may be driven into the blocking state. The circuit for current measurement 1300 needs not to rely on a resistive measurement. It is also possible to use measurement devices based on magnetic measurement (Hall measurement, TMR (tunnel magneto-resistance) measurement, Rogowski current transducer, etc.) or other types of current measurement.

Generally, there is a tradeoff in terms of cost and current carrying capacity between using power modules (where the interconnect between a plurality of power transistor chips is provided by conductive traces on an insulating substrate such as a ceramic-based substrate) or replacing them by a plurality of discrete component packages using cheaper, lower power components and no insulating substrate with conductive traces. This disclosure may shift the tradeoff in favor of using discrete component packages rather than power modules by increasing the current-carrying capability of discrete component packages of a given chip size and/or decreasing the chip size (and thus package cost) for a given current-carrying capability.

### EXAMPLES

The following examples pertain to further aspects of the disclosure:
Example 1 is a power transistor chip package which includes a power transistor chip. The power transistor chip includes a first load electrode on a first side, a second load electrode on a second side opposite the first side and a control electrode. The power transistor chip package further includes a chip pad on which the power transistor chip is disposed. The first side faces the chip pad and the first load electrode is electrically connected to the chip pad. An encapsulation body encapsulates the power transistor chip. The encapsulation body includes a footprint side, a top side opposite the footprint side and side faces extending between the footprint side and the top side. The power transistor chip package further includes a first package load terminal electrically connected to the first load electrode of the power transistor chip, part I and part II second package load terminals both electrically connected directly to the second load electrode of the power transistor chip and a package control terminal electrically connected to the control electrode of the power transistor chip. The part I and part II second package load terminals are aligned with opposite sides faces of the encapsulation body.
In Example 2, the subject matter of Example 1 can optionally include wherein the first package load terminal is disposed at the top side of the encapsulation body.
In Example 3, the subject matter of Example 1 can optionally include wherein the first package load terminal is disposed at the footprint side of the encapsulation body.
In Example 4, the subject matter of any preceding Example can optionally further include an electrical interconnect configured to connect the second load electrode to the part I and the part II second package load terminals, wherein the electrical interconnect comprises at least a bond wire or a ribbon or a clip.
In Example 5, the subject matter of any preceding Example can optionally include wherein the electrical interconnect comprises a part I electrical interconnect connecting the second load electrode to the part I second package load terminal and a part II electrical interconnect connecting the second load electrode to the part II second package load terminal, wherein the electrical resistance of the part I electrical interconnect and the electrical resistance of the part II electrical interconnect do not differ from each other by more than 200 or 10% or 5%.
In Example 6, the subject matter of any preceding Example can optionally further include an additional package control terminal, wherein the package control terminal and the additional package control terminal are aligned with the opposite sides faces of the encapsulation body.
In Example 7, the subject matter of any preceding Example can optionally further include an additional package sense terminal, wherein the package sense terminal and the additional package sense terminal are aligned with the opposite sides faces of the encapsulation body.
In Example 8, the subject matter of any preceding Example can optionally further include a package signal terminal, wherein the package signal terminal is connected to the first load electrode and is aligned with the side face opposite a side face at which the package control terminal is aligned.
In Example 9, the subject matter of any preceding Example can optionally include wherein the part I and the part II second package load terminals are each formed of a plurality of gull wing leads.
In Example 10, the subject matter of any preceding Example can optionally include wherein a maximum load current of the power transistor chip package is equal to or greater than 20 A, 40 A, 60 A, 70 A, or 80 A.
In Example 11, the subject matter of Example 10 can optionally include wherein the power transistor chip package is configured for switching voltages equal to or greater than 200 V, 400 V, 600 V, 800 V, 1 kV, or 1.2 kV.
Example 12 is a power circuit comprising first and second power transistor chip packages of any of the preceding Examples; a carrier, wherein the first and second power transistor chip packages are mounted at opposite sides to the carrier; and first and second heat sinks, wherein the first package load terminal of the first power transistor chip package is connected to the first heat sink and the first package load terminal of the second power transistor chip package is connected to the second heat sink.
In Example 13, the subject matter of Example 12 can optionally further include a first power connector connected to the first heat sink and/or a second power connector connected to the second heat sink, wherein the first heat sink and/or the second heat sink form part of the power connectivity of the power circuit.
In Example 14, the subject matter of Example 12 or 13 can optionally further include wherein a part I and/or part II second package load terminal of the first power transistor chip package and a part I and/or part II package load terminal of the second power transistor chip package are electrically connected via the carrier.
In Example 15, the subject matter of any of Examples 12 to 14 can optionally further include third and fourth power transistor chip packages of any of the preceding claims, wherein the third power transistor chip package is arranged side-by-side to the first power transistor chip package and the fourth power transistor chip package is arranged side-by-side to the second power transistor chip package; and wherein the first package load terminal of the third power transistor chip package is connected to the first heat sink and the first package load terminal of the fourth power transistor chip package is connected to the second heat sink.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A power transistor chip package, comprising:
a power transistor chip comprising a first load electrode on a first side, a second load electrode on a second side opposite the first side and a control electrode;
a chip pad on which the power transistor chip is disposed, the first side facing the chip pad and the first load electrode being electrically connected to the chip pad;
an encapsulation body encapsulating the power transistor chip, the encapsulation body comprising a footprint side, a top side opposite the footprint side and side faces extending between the footprint side and the top side;
a first package load terminal electrically connected to the first load electrode of the power transistor chip;
part I and part II second package load terminals both electrically connected directly to the second load electrode of the power transistor chip; and
a package control terminal electrically connected to the control electrode of the power transistor chip; wherein
the part I and the part II second package load terminals are aligned with opposite sides faces of the encapsulation body.

2. The power transistor chip package of claim 1, wherein the first package load terminal is disposed at the top side of the encapsulation body.

3. The power transistor chip package of claim 1, wherein the first package load terminal is disposed at the footprint side of the encapsulation body.

4. The power transistor chip package of any of the preceding claims, further comprising:
an electrical interconnect configured to connect the second load electrode to the part I and the part II second package load terminals, wherein the electrical interconnect comprises at least a bond wire or a ribbon or a clip.

5. The power transistor chip package of claim 4, wherein the electrical interconnect comprises
a part I electrical interconnect connecting the second load electrode to the part I second package load terminal and
a part II electrical interconnect connecting the second load electrode to the part II second package load terminal, wherein
the electrical resistance of the part I electrical interconnect and the electrical resistance of the part II electrical interconnect do not differ from each other by more than 200 or 10% or 5%.

6. The power transistor chip package of any of the preceding claims, further comprising:
an additional package control terminal, wherein the package control terminal and the additional package control terminal are aligned with the opposite sides faces of the encapsulation body.

7. The power transistor chip package of any of the preceding claims, further comprising:
an additional package sense terminal, wherein the package sense terminal and the additional package sense terminal are aligned with the opposite sides faces of the encapsulation body.

8. The power transistor chip package of any of the preceding claims, further comprising:
a package signal terminal, wherein the package signal terminal is connected to the first load electrode and is aligned with the side face opposite a side face at which the package control terminal is aligned.

9. The power transistor chip package of any of the preceding claims, wherein the part I and the part II second package load terminals are each formed of a plurality of gull wing leads.

10. The power transistor chip package of any of the preceding claims, wherein a maximum load current of the power transistor chip package is equal to or greater than 20 A, 40 A, 60 A, 70 A, or 80 A.

11. The power transistor chip package of any of the preceding claims, wherein the power transistor chip package is configured for switching voltages equal to or greater than 200 V, 400 V, 600 V, 800 V, 1 kV, or 1.2 kV.

12. A power circuit comprising:
first and second power transistor chip packages of any of the preceding claims;
a carrier, wherein the first and second power transistor chip packages are mounted at opposite sides to the carrier; and
first and second heat sinks, wherein the first package load terminal of the first power transistor chip package is connected to the first heat sink and the first package load terminal of the second power transistor chip package is connected to the second heat sink.

13. The power circuit of claim 12, further comprising:
a first power connector connected to the first heat sink and/or a second power connector connected to the second heat sink, wherein the first heat sink and/or the second heat sink form part of the power connectivity of the power circuit.

14. The power circuit of claim 12 or 13, wherein a part I and/or part II second package load terminal of the first power transistor chip package and a part I and/or part II package load terminal of the second power transistor chip package are electrically connected via the carrier.

15. The power circuit of any of claims 12 to 14, further comprising:
third and fourth power transistor chip packages of any of the preceding claims, wherein the third power transistor chip package is arranged side-by-side to the first power transistor chip package and the fourth power transistor chip package is arranged side-by-side to the second power transistor chip package; and wherein
the first package load terminal of the third power transistor chip package is connected to the first heat sink and
the first package load terminal of the fourth power transistor chip package is connected to the second heat sink.
